# EUROPÄISCHE PATENTSCHRIFT

(11) **EP 1 787 164 B1**
(45) Veröffentlichungstag und Bekanntmachung des Hinweises auf die Patenterteilung: **24.06.2009**
(21) Anmeldenummer: 05769575.1
(22) Anmeldetag: 27.07.2005
(51) Int. Cl.: G03F 7/00

(54) **VERFAHREN ZUR STRUKTURIERUNG EINES SUBSTRATS UND VORRICHTUNG HIERZU**
METHOD AND DEVICE FOR STRUCTURING A SUBSTRATE
PROCEDE ET DISPOSITIF POUR STRUCTURER UN SUBSTRAT

(30) Priorität: 09.09.2004 DE 102004044083
(43) Veröffentlichungstag der Anmeldung: 23.05.2007
(73) Patentinhaber: Forschungszentrum Jülich GmbH, 52425 Jülich (DE)
(72) Erfinder: SZOT, Krysztof, 52428 Jülich (DE); PETER, Frank, 01109 Dresden (DE); REICHENBERG, Bernd, 52068 Aachen (DE)
(86) Internationale Anmeldenummer: PCT/DE2005/001321
(87) Internationale Veröffentlichungsnummer: WO 2006/026941

(56) Entgegenhaltungen:
- US-A- 4 440 493
- US-A- 6 093 445
- HUI YOU ET AL: "Deep x-ray exposure system with multistage for 3-D microfabrication" MICROMECHATRONICS AND HUMAN SCIENCE, 2000. MHS 2000. PROCEEDINGS OF 2000 INTERNATIONAL SYMPOSIUM ON OCTOBER 22-25, 2000, PISCATAWAY, NJ, USA,IEEE, 22. Oktober 2000 (2000-10-22), Seiten 53-58, XP010531638 ISBN: 0-7803-6498-8
- TERRIS B D ET AL: "Ion-beam patterning of magnetic films using stencil masks" APPLIED PHYSICS LETTERS, AIP, AMERICAN INSTITUTE OF PHYSICS, MELVILLE, NY, US, Bd. 75, Nr. 3, 19. Juli 1999 (1999-07-19), Seiten 403-405, XP012024410 ISSN: 0003-6951
- ANONYMOUS: "45-Degree Aperture Pair for E-Beam Spot Shaping. July 1982." IBM TECHNICAL DISCLOSURE BULLETIN, Bd. 25, Nr. 2, 1. Juli 1982 (1982-07-01), Seiten 597-600, XP002371185 New York, US

## Beschreibung

Die Erfindung betrifft ein Verfahren zur Strukturierung eines Substrats und eine Vorrichtung hierzu.

Aus Hui You et al. (Deep ray exposure system with multistage for 3D microfabrication. Micromechatronics and Human Science, 2000. MHS 2000. Proc. of 2000 Int. Symp. on October 20-25, 2000, Piscataway, NJ, USA. IEEE, 22.10.2000, Seiten 53-58. ISBN 0-7803-6498-8) ist ein Verfahren und eine Vorrichtung zur Erzeugung von 3D-Strukturen bekannt.

US 6,093,445 A offenbart ein Verfahren und eine Vorrichtung zur Erzeugung von Mikrostrukturen, bei der ein Substrat über einen Halter an einen X-Y-Aktuator bzw. Z-Aktuator gekoppelt ist.

Terris B. D. et al. (Ion-beam patterning of magnetic films using stencil masks. Applied Physics Letters, Bd. 75, Nr. 3, Seiten 403-405) offenbaren ein Verfahren und eine Vorrichtung zur Erzeugung kleiner magnetischer Strukturen. Dabei werden zwei Masken mit partiell überlappender Struktur angeordnet, um kleinere Strukturen schreiben zu können, als durch die Öffnungen in den Masken definiert.

Kohler J. et al. (Direct growth of nanostructures by deposition through an Si3N4 shadow mask. Physica E, Vol. 4, no 3, p. 196-200 (1999)) offenbaren eine Verengung der Maskenöffnungen nach Deposition.

Ein wichtiger Schritt bei der Herstellung von Halbleiter-Bauelementen ist die Strukturierung eines Substrats. Auf dem Substrat werden Bereiche markiert, die nachfolgend z. B. weggeätzt oder metallisiert werden. Durch mehrere aufeinander folgende Prozessschritte werden so die Grundelemente von passiven und aktiven Bauelementen hergestellt.

Industriell wird hierzu die optische Lithographie angewandt. Die Lithographie dient der Übertragung der Strukturen eines Entwurfs eines integrierten Bauelements auf Halbleiterscheiben unter Anwendung verschiedener Bestrahlungsmethoden, entweder direkt oder indirekt mittels Masken, wobei auch die Verfahren zur Herstellung der Masken zur Lithographie gerechnet werden.

Ausgangspunkt aller Lithographieverfahren ist der in Datenform auf einem Speichermedium vorliegende Entwurf eines Bauelements. Dieser muss als geometrisches Muster auf ein Trägermaterial, ein Substrat oder auf eine auf einem Substrat angeordnete Schicht, übertragen werden.

Bei indirekten Lithographieverfahren wird so die erforderliche Zahl von Muttermasken hergestellt, während bei den direkten Verfahren das Muster unmittelbar auf den Wafer aufgebracht wird, mit der erforderlichen Zahl von Durchgängen, um die sich aus dem Entwurf ergebende Komplexität des Bauelements zu erhalten. Auf dem zu belichtenden Material wird zuvor eine strahlungsempfindliche Schicht, der Photolack, aufgebracht, die durch die Bestrahlung an den belichteten Stellen eine Veränderung erfährt. Dadurch wird eine selektive Entfernung der bestrahlten (Positivverfahren) oder der unbestrahlten Gebiete (Negativverfahren) möglich. Die verbleibende Schicht soll das unter ihr befindliche Material vor den Einflüssen der nachfolgenden Prozessschritte schützen. Während es bei der Maskenherstellung nur auf die Erzeugung strahlungsdurchlässiger und/oder absorbierender Gebiete ankommt, werden den Halbleiterscheiben als Substrate durch chemische Prozesse, wie z. B. Aufdampfen, Epitaxie, Implantation, Deposition) die eigentlichen Funktionselemente wie Leiterbahnen, Dioden oder Transistoren eingeprägt und somit strukturiert.

Bei den indirekten Lithographieverfahren wird das Halbleitermaterial unter Zwischenschalten der Masken belichtet, wobei verschiedene Strahlungsarten verwendet werden können. Das derzeit gängigste Verfahren, ist die Photolithographie oder auch optische Lithographie genannt.

Masken werden zur Übertragung der Strukturen auf oder in das Halbleitersubstrat (Halbleiterscheiben oder Wafer) verwendet. Zunächst wird die benötigte Anzahl an Masken hergestellt. Die Muster der Masken werden dann der Reihe nach auf das jeweils zuvor durch Beschichtung mit Photolack sensibilisierte Substrat übertragen. Nach jeder Belichtung wird das Substrat, nach der Entfernung des Fotolacks an den belichteten bzw. unbelichteten Stellen je nach Verfahren, den Prozessen unterworfen, durch die es die im Entwurf konzipierten elektronischen Eigenschaften erhält.

Die Masken als Träger der geometrischen Informationen bestehen typischerweise aus Glas als Substrat mit einer etwa 100 nm dicken Schicht aus Chrom oder Chromoxid, die durch Nass- oder Trockenätzen an bestimmten Stellen entfernt wird, um das gewünschte Muster zu erzeugen. Die Übertragung der Struktur auf das Halbleitermaterial wird bei allen verwendeten Strahlungsarten einheitlich als Belichtung bezeichnet.

Die bei Maskenlithographieverfahren verwendeten Masken enthalten die Strukturen im Maßstab 1:1. Neben Projektionsverfahren gibt es die Kontaktbelichtung, bei der die Maske mit der Musterseite auf den Wafer gepresst wird, und die Proximitybelichtung mit einem Abstand von etwa 10 bis 20 Mikrometer zwischen Maske und Wafer.

Lochmasken werden auch für andere Strukturierungsverfahren wie z. B. Implantationen von Ionen oder Deposition von z. B. Metallen in bzw. auf das Substrat eingesetzt.

Für spezielle Anwendungen, wie die Herstellung von Masken sowie in Forschung und Entwicklung, werden auch kürzerwellige und energiereichere Strahlen, wie Röntgenstrahlen (Röntgenstrahllithographie), Elektronenstrahlen und Ionenstrahlen (Ionenstrahllithographie), verwendet, die eine höhere laterale Auflösung und damit größere Integrationsdichte der Bauelemente erlauben.

Beispielhaft seien die extreme Ultraviolett Lithographie mit einer Wellenlänge der Strahlung von etwa 11-14 Nanometern, die Röntgenstrahllithographie (Strahlung kleiner 10 Nanometer) und das Elektronenstrahlschreiben genannt, bei der die Struktur direkt mittels eines Elektronenstrahls in den Lack auf einem Substrat geschrieben wird und keine Maske erforderlich ist.

Vergleichbar mit der Elektronenstrahllithographie ist die Ionenstrahllithographie, während der, anstatt mit Elektronen, mit einem Ionenstrahl auf das Substrat geschrieben wird.

Bei dem so genannten Nanoimprint-Verfahren wird ein Stempel mit feinen Strukturen in ein Resist gedrückt. Das Resist wird ausgehärtet und der Stempel wird entfernt.

Ebenfalls bekannt ist die Dip Pen Nanolithographie^{™} (DPN^{™}). Dabei wird ein Verfahren verwendet bei der zur Erzeugung kleinster Nanostrukturen mit molekularer "Tinte" auf einem Substrat geschrieben wird. Die Moleküle werden mit einem modifizierten Rastersondenmikroskop auf das Substrat gebracht.

Nachteilig weisen die genannten Verfahren Schwächen bei der Herstellung der Nano-Strukturen auf.

Bei der optischen Lithographie ist die minimal erzeugbare Strukturgröße durch die Wellenlänge begrenzt. Die während der extremen Ultraviolettlithographie zu benutzenden Linsen und Spiegel sind in der Herstellung sehr teuer und die erreichbare Fertigungsqualität der optischen Komponenten ist begrenzt.

Das Elektronenstrahlschreiben wendet zur Erzielung hoher Auflösungen im Bereich von etwa 10 Nanometern ein serielles Schreiben an, dass für die industrielle Anwendung als zu langsam erscheint. Selbiges gilt für die Ionenstrahllithographie. Ebenfalls nachteilig ist die Rückstreuung der Ionen, die von der Struktur abhängt. Das Nanoimprintverfahren wird hingegen durch die Zeit, die benötigt wird, damit der Resist aushärtet, begrenzt. Der Durchsatz zur Strukturierung von Halbleiter-Bauelementen ist deshalb begrenzt. Bisher wurde diese Methode auch nur auf ebenen und nicht auf texturierten Oberflächen angewendet. Für die Halbleiterherstellung ist eine Strukturierung auf einer vorhandenen Textur nötig.

Somit ist nachteilig jedes der genannten Verfahren entweder durch die Maskenstruktur oder den Aufwand zur Überwindung der minimalen Strukturen in der Maske limitiert.

Aufgabe der Erfindung ist es daher, ein weiteres Verfahren bereit zu stellen, mit dem Strukturen kleiner als z. B. 50 Nanometer hergestellt werden können.

Die Aufgabe wird durch ein Verfahren gemäß Hauptanspruch und eine Vorrichtung gemäß Nebenanspruch gelöst. Vorteilhafte Ausgestaltungen ergeben sich aus den darauf jeweils rückbezogenen Patentansprüchen.

Das Verfahren zur Strukturierung des Substrats sieht vor, mindestens eine Maske mit einer Öffnung über dem Substrat anzuordnen. Durch die mindestens eine Maske werden unmaskierte Bereiche gegenüber maskierten Bereichen des Substrats zur Bildung von Strukturen während des Verfahrens verändert. Es ist möglich, an Stelle eines Substrats eine auf dem Substrat angeordnete Schicht zu strukturieren bzw. zu verändern.

Das Verfahren zur Strukturierung eines Substrats sieht vor, mindestens eine Maske mit einer Öffnung über dem Substrat anzuordnen und unmaskierte Bereiche gegenüber maskierten Bereichen des Substrats zur Bildung von Strukturen zu verändern. Während der Strukturierung werden Maßnahmen getroffen, mit denen eine Abbildung der Maskenöffnung auf und/oder in dem Substrat erzeugt wird, welche kleinere Abmessungen aufweist, als die reale Abmessung der Maskenöffnung. Das Verfahren ist dadurch gekennzeichnet, dass mittels einer Diodenanordnung die Fläche der Maskenöffnung kontrolliert wird.

Dadurch wird vorteilhaft bewirkt, dass Veränderungen der Fläche der Öffnungen kontrolliert und kleinere Strukturen auf oder in dem Substrat abgebildet und erzeugt werden. Die begrenzte minimale Struktur, die durch die Herstellung der Maske oder das angewendete Verfahren bedingt ist, wird dadurch überwunden.

In Abhängigkeit von der gewählten Geometrie des Bewegungsablaufs relativ zwischen Substrat und Maskenöffnung(en) kann besonders vorteilhaft die Geometrie der Struktur im Substrat erzeugt werden.

Es können mindestens zwei Masken mit Öffnungen axial, das heißt in z-Richtung übereinander über einem Substrat angeordnet werden. Wiederum in z-Richtung über den Masken können die Strukturierungsquellen angeordnet sein, z. B. Implantations- oder Depositionsquellen.

Beispielhaft können zwei gleiche Masken mit einem identischen Muster an Maskenöffnungen in z-Richtung über dem Substrat angeordnet sein. Sofern die Öffnungen der Masken in der Projektion geringfügig und in definierter Weise zueinander in X- und/oder Y-Richtung versetzt sind, werden definiert Abbildungen in dem Substrat erzeugt, die durch die Größe der Überlappung der Maskenöffnungen definiert werden. Mittels eines geeigneten Strukturierungsverfahrens, z. B. einer Deposition, werden kleinere Strukturen gebildet als durch die realen Maskenöffnungen vorgegeben.

Es können eine Vielzahl identischer Maskenöffnungen in den Masken zueinander in X- und/oder Y-Richtung versetzt angeordnet sein. Dadurch wird vorteilhaft bewirkt, dass auf einfache Weise viele identische Strukturen in oder auf dem Substrat erzeugt werden, die kleiner sind als durch die Maskenöffnungen vorgegeben. Die Strukturen bzw. Bereiche weisen definierte Abmessungen in Abhängigkeit des Überlapps der Maskenöffnungen auf.

Es können in Abhängigkeit von dem zu erzielenden Resultat selbstverständlich auch mehr als zwei Masken verwendet und in z-Richtung axial übereinander sowie in X- und/oder Y-Richtung versetzt zueinander angeordnet werden. Die Masken sind während des Strukturierungsverfahrens ortsfest über dem Substrat angeordnet.

In einer besonders vorteilhaften Ausgestaltung der Erfindung wird hingegen mindestens eine Maske während des Verfahrens relativ zum Substrat so bewegt, dass keine maßstabsgetreue, sondern eine kleinere Abbildung der Maskenöffnung erzeugt wird. Diese Abbildung weist eine, je nach Geometrie des Bewegungsablaufs der Maske, andere Form auf, als die Maskenöffnung. Auch durch diese Maßnahme allein, wird die Aufgabe der Erfindung gelöst und auf dem Substrat eine Struktur erzeugt, welche kleiner ist als durch die reale Abmessung der Maskenöffnung vorgegeben.

Während des Verfahrens wird eine Deposition oder eine Implantation oder auch Kombinationen dieser Verfahrensschritte zur Erzeugung von kleinsten Strukturen ausgeführt. Durch eine Deposition werden z. B. Metallisierungen und isolierende Schichten erzeugt. Durch die Implantation werden nano-Bereiche p- und n-dotiert.

Je nach Verfahrensschritt werden auf diese Weise durch Anordnen und/oder Bewegen der Maske(n) relativ über dem Substrat kleinste Strukturen gebildet.

Sofern während des Verfahrens mindestens eine Maske über das Substrat bewegt wird, kann in Abhängigkeit von der Geometrie des Bewegungsablaufs der Maske, die Struktur erzeugt werden. Eine rechteckige Bewegung einer runden bzw. viereckigen Maskenöffnung erzeugt während einer während der Bewegung durchgeführten Strukturierung, z. B. einer Deposition oder Implantation eine entsprechende rechteckige Struktur in oder auf dem Substrat. Kreisrunde oder elliptische Bewegungen können zu entsprechenden Geometrien der Struktur in oder auf dem Substrat führen. Dabei werden jeweils Strukturen mit kleineren Abmessungen als die realen Maskenöffnung erzeugt.

Es kann auch eine Maske umfassend magnetisches Material gewählt werden. Derartige Masken sind durch Magneten bewegbar oder werden über einen diesen umfassenden Objektträger ortsfest positioniert.

Das Verfahren kann diskontinuierlich durchgeführt werden. Z. B. kann die Deposition oder Implantation während der Relativbewegung zeitweilig ausgesetzt werden. Es kann aber auch die Bewegung der Maske(n) relativ zum Substrat während einer kontinuierlich verlaufenden Strukturierung diskontinuierlich durchgeführt werden. Auch beide Prozesse, also die Bewegung und der Strukturierungsprozess (z. B. Deposition) können diskontinuierlich durch Blenden durchgeführt werden. Es können beispielsweise zwei Masken axial, das heißt in z-Richtung übereinander auf dem Substrat angeordnet sein, deren in der Projektion überlappende Bereiche durch Versetzung in X- und oder Y-Richtung eine kleinere Abbildung der Öffnungen auf dem Substrat erzielen. Während der Strukturierung, z. B. während einer Deposition, wird diese zeitweilig ausgesetzt und beide Masken in gleicher Weise und relativ zum Substrat zu einer Position bewegt. Sodann wird erneut deponiert.

Dadurch wird besonders vorteilhaft bewirkt, dass diffus während der Bewegung und zeitweilig strukturierte Bereiche bzw. Flächen auf/in dem Substrat reduziert oder gar ganz vermieden werden.

Alternativ kann die mindestens eine Maske ortsfest verbleiben und das Substrat bewegt werden.

Durch die Bewegung der Maske(n) in einer bestimmten geometrischen.Abfolge relativ zum Substrat und einer geeigneten kontinuierlichen oder diskontinuierlichen Strukturierung, beispielsweise durch eine diskontinuierliche Deposition oder aber auch durch eine diskontinuierliche Bewegung der mindestens einen Maske relativ zum Substrat, wird immer eine Struktur auf oder in dem Substrat erzeugt, die kleiner ist, als die real vorhandenen Maskenöffnung(en) und gegebenenfalls eine definiert vorhersehbar andere Form als diese aufweisen.

Mehrere, insbesondere zwei oder vier Masken, können demnach während des Verfahrens relativ zum Substrat bewegt werden. Die Masken mit Öffnungen können, müssen sich aber nicht untereinander relativ zu anderen Masken bewegen, um kleinste Strukturen während der Strukturierung, z. B. einer Deposition in oder auf dem Substrat zu erzeugen.

Eine erfindungsgemäße Vorrichtung zur Strukturierung eines Substrats oder von einer auf einem Substrat aufgebrachten Schicht weist erfindungsgemäß Mittel zur Ausführung von Bewegungen relativ zwischen mindestens einer Maske mit mindestens einer Maskenöffnung und dem Substrat auf.

Eine erfindungsgemäße Vorrichtung zur Durchführung des Verfahrens kann aber auch mindestens zwei übereinander in z-Richtung angeordnete Masken mit Maskenöffnungen umfassen, deren Maskenöffnungen in X- und/oder Y-Richtung zueinander versetzt sind. In z-Richtung über dem Substrat sind dann mindestens die beiden Masken und die Strukturierungsquelle, z. B. eine Depositionsquelle angeordnet. Die Vorrichtung ist gekennzeichnet durch eine Diodenanordnung, mit der die Veränderung der Fläche der Maskenöffnungen kontrolliert wird.

Als Mittel zur Bewegung von Maske(n) weist die Vorrichtung in einer besonders vorteilhaften Ausgestaltung der Erfindung mindestens ein Piezoelement/Piezoaktuator auf. Die Vorrichtung kann die Relativbewegung mittels Trägheitsantrieb ausführen.

In der Vorrichtung kann mindestens eine Maske auf einem Objektträger angeordnet sein. Der Objektträger ist so ausgeführt, dass er die Maske z. B. an deren Rändern trägt. Der Objektträger ist hierzu ebenfalls mit einer Öffnung versehen, die die Öffnung der getragenen Maske so umschließt, dass der Durchtritt des deponierten oder implantierten Materials durch die Maskenöffnung und der Öffnung des Objektträgers während der Strukturierung möglich ist.

Durch Deposition oder Implantation eines Materials auf oder in einen nicht abgedeckten Bereich des Substrats wird die Struktur erzeugt.

Das oder die Piezolemente können seitlich an der oder den Masken angeordnet sein.

Die Information über die relative Position der Masken zum Substrat kann über optische, interferometrische und/oder kapazitive Sensoren erfolgen.

Das oder die Piezoelement bewegen die Maske(n) über das Substrat.
Es ist möglich, die Maske direkt an den Piezoelementen anzuordnen und durch diese zu bewegen. Dann kann auf den Objektträger verzichtet werden. Die Maske kann hierzu über mindestens ein an der Maske angeklebtes Piezoelement bewegt werden.

Es ist auch möglich, durch mindestens ein Piezoelement das Substrat zu bewegen. Es ist weiterhin möglich, ein Substrat, welches in einem Objektträger angeordnet ist durch mindestens ein Piezoelement zu der oder zu den Masken zu bewegen.

Auf diese Weise ist eine Relativbewegung zwischen Substrat und mindestens einer Maske durchführbar.

Besonders vorteilhaft weist die Vorrichtung einen Objektträger umfassend einen Magneten oder eine Vakuumapparatur für die Maske auf. Sofern die Maske magnetisches Material umfasst, kann diese sicher durch den Objektträger gehalten und bewegt werden.

Die Vorrichtung weist vorteilhaft für jedes zu bewegende Objekt mindestens drei Pieozelemente auf. Damit ist eine Dreipunktlagerung des zu bewegenden Objekts möglich. Als zu bewegendes Objekt gilt der Objektträger, die Maske(n) oder das Substrat.

Die Vorrichtung kann einen Nanomanipulator umfassen. Die Mittel zur Bewegung sind Bestandteil des Nanomanipulators.

Besonders vorteilhaft weist die Vorrichtung eine Steuerungseinheit zur nacheinander ablaufenden Relativbewegung der Maske zum Substrat auf, z. B. einen Computer.

Die Vorrichtung vermag diskontinuierliche Bewegungs- und/oder Strukturierungsabläufe auszuführen.

Hierzu weist die Vorrichtung vorteilhaft Blendenanordnungen zur diskontinuierlichen Strukturierung auf. Die Blendenanordnung wird zwischen die Maske(n) und z. B. eine Depositionsquelle als Strukturierungsquelle geschoben. Die Blendenanordnung unterbricht dann eine Deposition als Strukturierungsprozess.

In Zusammenhang mit der erfindungsgemäßen Diodenanordnung, welche unterhalb der Maskenöffnungen angeordnet ist, ist es möglich mittels eines auf die Maskenöffnungen gerichteten UV-Strahls die Verstopfung der Masken zu kontrollieren. Korrekturen an der Vorrichtung sind so rechtzeitig durchführbar, bevor es zu einer Verkleinerung der Maskenöffnungen durch eine Deposition kommt. Eine Kontrolle der Veränderung der Fläche der Maskenöffnungen ist möglich.

Im Weiteren wird die Erfindung an Hand von Ausführungsbeispielen und den beigefügten Figuren näher beschrieben.

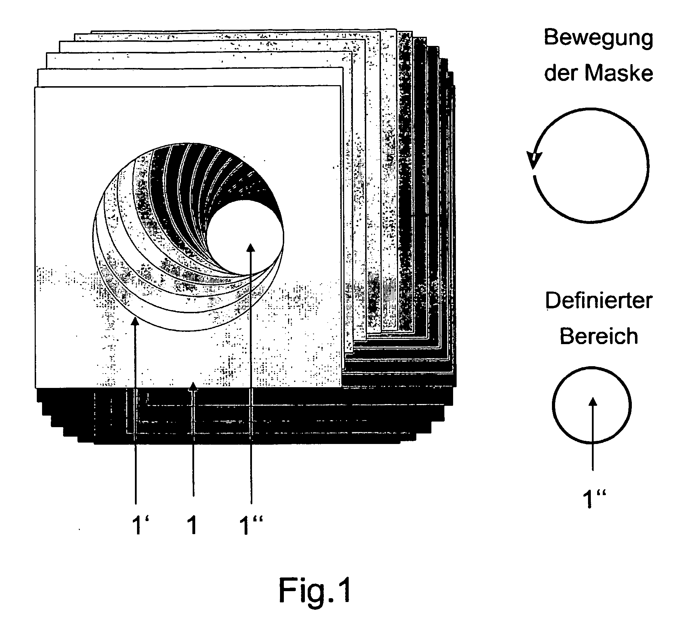

Die Figuren 1 bis 4 zeigen in Aufsicht den Bewegungsablauf einer quadratischen Maske 1, 21, 31 und 41 zur Strukturierung eines Substrats, welches nicht dargestellt ist. Der Bewegungsablauf der Masken ist durch die Veränderung der Schattierung der Maske von schwarz nach hellgrau wiedergegeben. Anfangs- und Endposition der Maske sind für den Abschluss des definierten Bereichs und zur Bildung der Struktur in oder auf einem Substrat identisch.

In Fig. 1 ist eine Maske 1 mit einer kreisförmigen Maskenöffnung 1' dargestellt. Die Maske führt zwischen Start- und Zielposition eine annähernd kreisförmige Bewegung in 21 Schritten durch.

Durch kontinuierliche Deposition der sich über einem Substrat bewegenden Maske wird ein kreisförmiger Bereich 1'' im Inneren der Maskenöffnung 1' definiert, der permanent während der Bewegung der Masken deponiert wird. Dieser Bereich 1'' wird auf das Substrat abgebildet. Das Substrat weist an dem definierten Bereich 1'' die veränderte Struktur im Vergleich zu den durch die Maske 1 abgedeckten Bereichen auf. Die Fläche der Maskenöffnung 1' beträgt z. B. 1963 mm² bei einem Radius von 25 mm. Der definierte, abgebildete Bereich 1'' weist bei einem Radius von 10 mm eine Fläche von 314 mm² auf. Der abgebildete Bereich 1'' weist somit eine um etwa 84 % geringere Fläche auf, als die Maskenöffnung 1'. Eine kontinuierliche Deposition führt dabei zu diffus definierten Bereichen an den Rändern des definierten Bereichs, die nur zum Teil deponiert wurden.

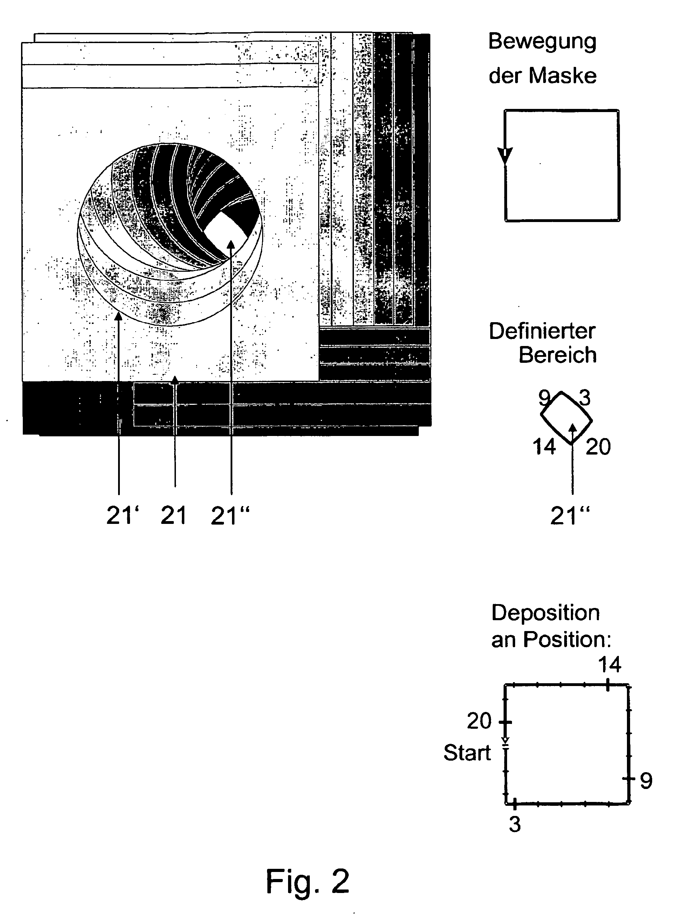

In Fig. 2 ist eine Maske 21 mit einer kreisförmigen Öffnung 21' dargestellt. Die Maske 21 führt zwischen Start- und Zielposition eine quadratische Bewegung in 21 Schritten durch.

Durch diskontinuierliche Deposition nur an den Positionen 3, 9, 14 und 20 der sich über dem Substrat bewegenden Maske wird ein etwa viereckiger, hell dargestellter Bereich 21'' im Inneren der Maskenöffnung 21' definiert, in dem viermal ein Material deponiert wird. Die Geometrie des Bereichs 21" wird demnach in nur vier Einzelschritten definiert. Die dazwischen liegenden Schritte hingegen tragen nicht zur Definition des Bereichs 21" bei. Das Substrat weist an dem definierten Bereich die veränderte Struktur im Vergleich zu den durch die Maske 1 abgedeckten Bereichen auf.

Die Fläche der Maskenöffnung 21' beträgt z. B. 1963 mm² bei einem Radius von 25 mm. Der definierte, abgebildete Bereich 21'' weist eine Fläche von 92,7 mm² auf. Der abgebildete Bereich 21" weist somit eine um etwa 95 % geringere Fläche auf, als die Maskenöffnung 21'.

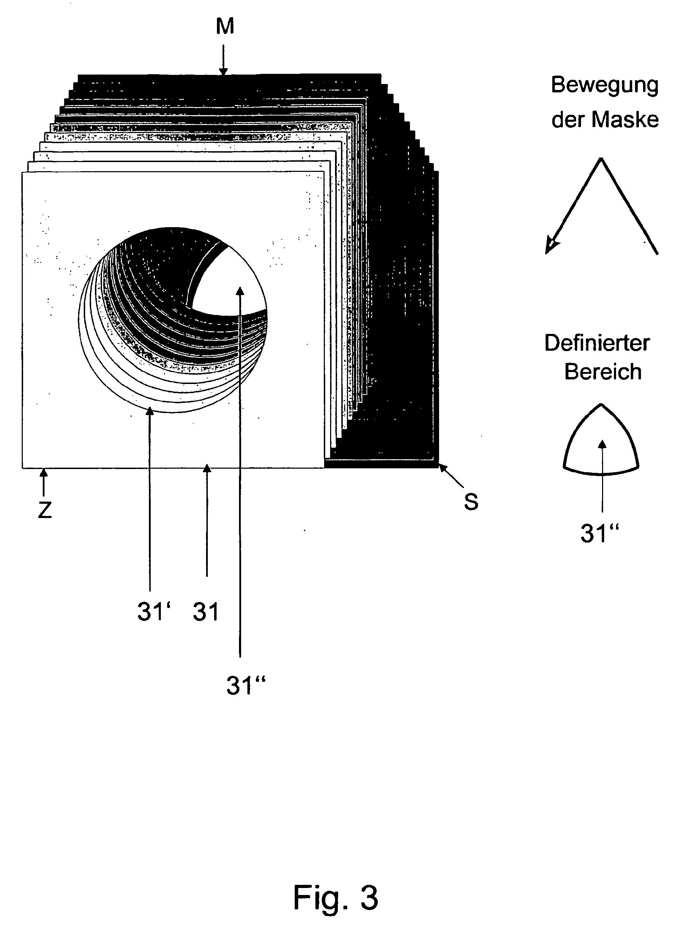

In Fig. 3 ist eine Maske 31 mit einer kreisförmigen Öffnung 31' dargestellt. Die Maske führt Bewegungen entlang eines gleichschenkligen Dreiecks, wie in der Fig. 3 rechts oben angegeben, in 23 Schritten durch.

Durch kontinuierliche oder diskontinuierliche Deposition der sich über dem Substrat bewegenden Maske 31 wird ein dreieckiger Bereich 31'' im Inneren der Maskenöffnung 31' definiert. Dieser Bereich 31'' wird auf das Substrat abgebildet. Das Substrat weist an dem definierten Bereich die veränderte Struktur im Vergleich zu den durch die Maske 31 abgedeckten Bereichen auf.

Die Fläche der Maskenöffnung 31' beträgt z. B. 1963 mm² bei einem Radius von 25 mm. Der definierte, abgebildete Bereich 31'' weist eine Fläche von 180 mm² auf. Der abgebildete Bereich 31'' weist somit eine um etwa 91 % geringere Fläche auf, als die Maskenöffnung 31'.

Eine kontinuierliche Deposition führt zu diffus definierten Bereichen an den Rändern des definierten Bereichs 31", die nur zum Teil deponiert wurden.

Durch eine diskontinuierliche Deposition an der Start-, Mittel- und Zielposition (S, M, Z), welches den Positionen 1, 12 und 23 entspricht, wird hingegen der definierte Bereich 31" durch nur drei Positionen erzeugt. Die dazwischen liegenden Schritte hingegen tragen nicht zur Definition des Bereichs 31" bei.

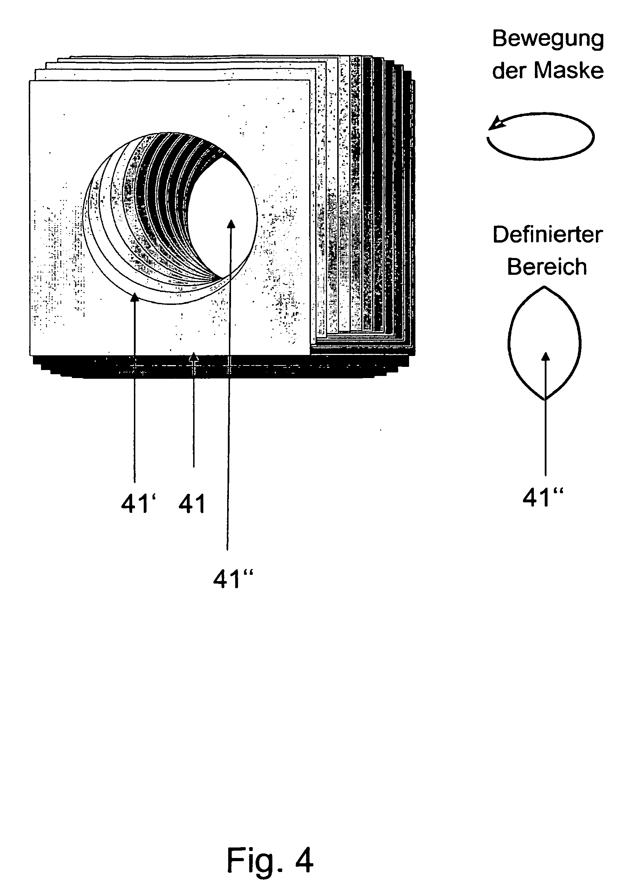

In Fig. 4 ist eine Maske 41 mit einer kreisförmigen Öffnung 41' dargestellt. Die Maske führt eine horizontal elliptische Bewegung in 23 Schritten durch, von denen nur die letzten 22 wiedergegeben sind.

Durch kontinuierliche Deposition der sich elliptisch über dem Substrat bewegenden Maske 41 wird ein vertikal elliptischer Bereich 41" im Inneren der Maskenöffnung 41' definiert. Dieser Bereich 41'' wird auf das Substrat abgebildet. Das Substrat weist an dem definierten Bereich 41'' die veränderte Struktur im Vergleich zu den durch die Maske 41 abgedeckten Bereichen auf.

Die Fläche der Maskenöffnung 41' beträgt z. B. 1963 mm² bei einem Radius von etwa 25 mm. Der definierte, ellipsoide Bereich 41'' weist eine Fläche von etwa 607 mm² auf. Der Bereich 41'' weist somit eine um etwa 69 % geringere Fläche auf, als die Maskenöffnung 41'.

Eine kontinuierliche Deposition führt wiederum zu diffus definierten Bereichen außerhalb des definierten Bereichs 41''.

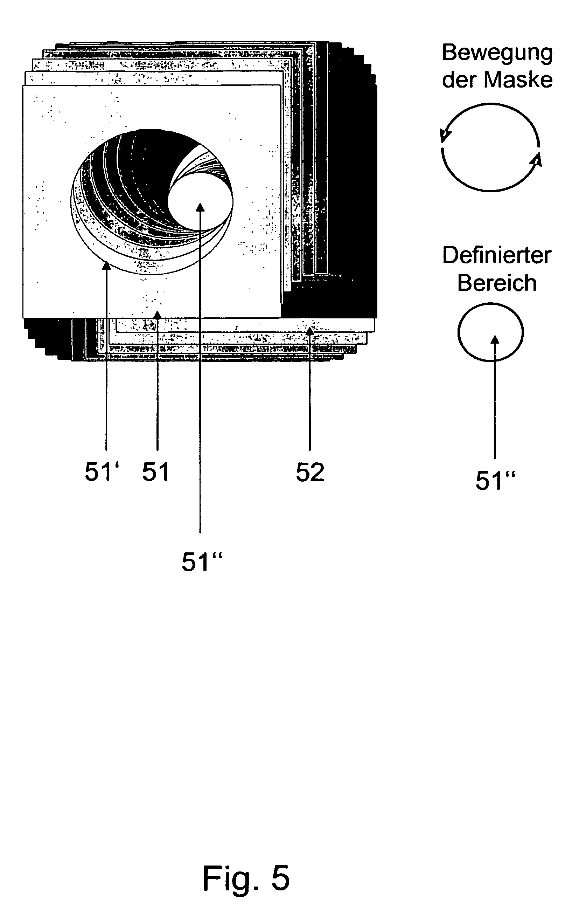

Die Figur 5 zeigt in Aufsicht den Bewegungsablauf zweier übereinander angeordneter quadratischer Masken 51 und 52 zur Strukturierung eines Substrats, welches wiederum nicht dargestellt ist. Der Bewegungsablauf jeder Maske ist durch die Veränderung der Schattierung der Masken von jeweils schwarz nach hellgrau wiedergegeben. Die Endposition von Maske 52 ist, für den Abschluss des definierten Bereichs 51'' und zur Bildung der Struktur in oder auf einem Substrat mit der Startposition von Maske 51 identisch und umgekehrt. Die Masken führen hierzu jeweils zumindest halbkreisförmige Bewegungen mit insgesamt 12 Positionen aus, um einen kreisförmigen Bereich 51'' auf oder in dem Substrat zu definieren und abzubilden.

Durch kontinuierliche Deposition der sich kreisförmig über dem Substrat bewegenden Masken 51, 52 wird der kreisförmige Bereich 51" im Inneren der Maskenöffnung 51' und 52' definiert und abgebildet. Die Maskenöffnung 52' ist auf Grund der Darstellungsweise nicht vollständig dargestellt. Der Bereich 51" wird auf das Substrat abgebildet. Das Substrat weist an dem definierten Bereich 51'' die veränderte Struktur im Vergleich zu den durch die Masken 51 und 52 abgedeckten Bereichen auf. Der definierte, abgebildete Bereich 51'' weist in Analogie zum Ausführungsbeispiel der Fig. 1 eine um etwa 84 % geringere Fläche auf, als die jeweilige Maskenöffnung 51' und 52'. Eine kontinuierliche Deposition führt zu einem diffus definierten Bereich an den Rändern des definierten Bereichs 51'', welcher vorteilhaft viel geringer ausfällt, als in Fig. 1.

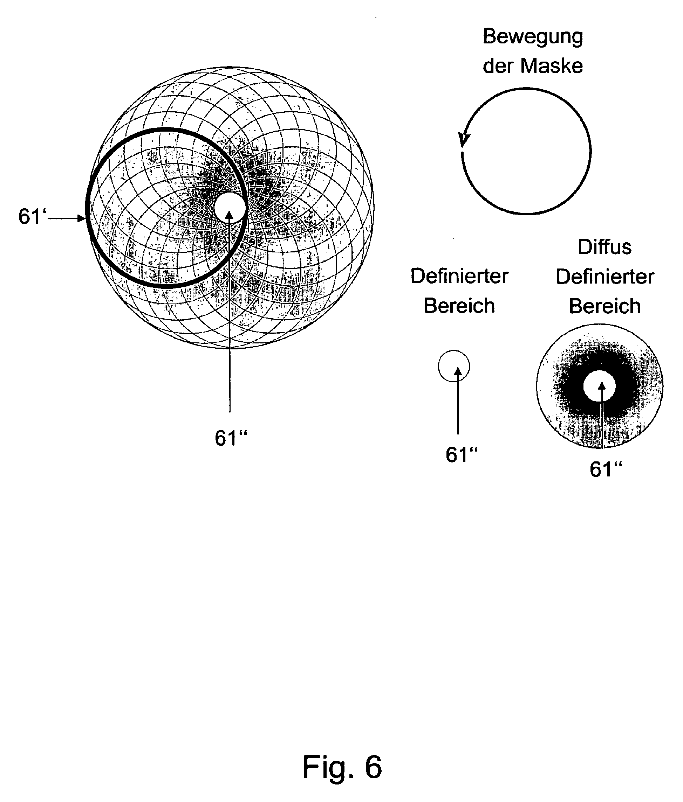

Derartige diffus definierte erzeugte Bereiche des Substrats bei kontinuierlicher Deposition bzw. Strukturierung sind in den Fig. 6 bis 8 für verschiedene Maskenanordnungen grau unterlegt.

Die Fig. 6 bis 8 zeigen in Aufsicht den Bewegungsablauf und die Positionen der Maskenöffnungen 61', 71', 72', 81', 82', 83' und 84' an Hand der dünnen durchgezogenen Kreise. Der jeweilige solide Bereich der Maske ist, anders als in den Fig. 1 bis 5, nicht dargestellt. Fett markierte Kreise stellen die Start- bzw. Endpositionen der Maskenöffnungen 61', 71', 72', 81', 82', 83' und 84' dar.

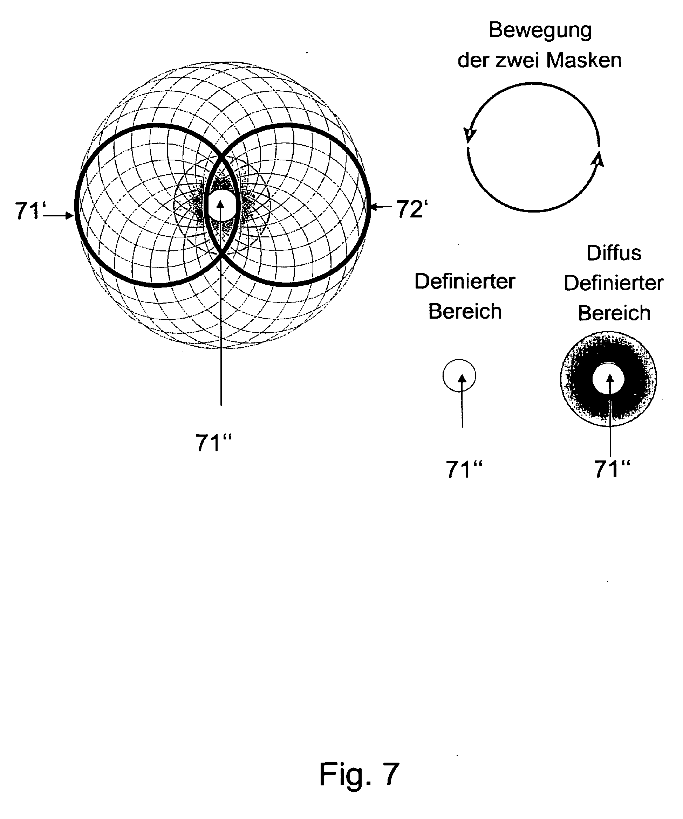

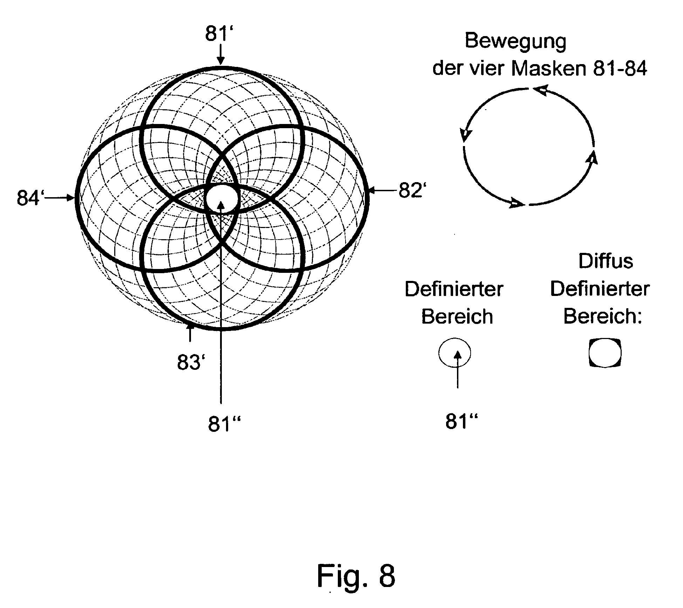

Jede Maske für sich und/oder in Kombination mit den anderen Masken (Fig. 7 und 8) führt kreisförmige Bewegungen aus, um zu einem kreisförmigen, definierten Bereich als Abbildung in bzw. auf dem Substrat zu gelangen. Es ist denkbar, andere Bewegungsabläufe mit anderen geometrischen Mustern ablaufen zu lassen, um zu anderen Strukturen auf oder in dem Substrat zu gelangen, s. Fig. 1 bis 4.

Fig. 6 zeigt den Bewegungsablauf einer Maskenöffnung 61' in Analogie zu dem der Maskenöffnung 1' in der Fig. 1. Fig. 7 zeigt den Bewegungsablauf der Maskenöffnung 71' und 72' in Analogie zu denen der Maskenöffnung 51' und 52' in der Fig. 5.

In Fig. 6 ist die Anfangs- und die Endposition der Maske für den Abschluss des definierten, kreisförmigen Bereichs 61" und zur Bildung der Struktur in oder auf einem Substrat identisch. Die kreisförmige Maskenöffnung 61' wird in 21 Schritten, dargestellt durch die dünnen durchgezogenen Kreise über ein in Bildebene hinter der Öffnung 61' gelegenes Substrat (nicht dargestellt) bewegt.

Eine Depositionsquelle kann in Bildebene vor der Maske angeordnet sein. Durch eine kontinuierliche Deposition der sich kreisförmig über dem Substrat bewegenden Maske wird über die Öffnung 61' ein kreisförmiger Bereich 61'' im Inneren der Maskenöffnung 61' definiert, der kleiner ist als die Fläche der Öffnung 61' der Maske. Dieser Bereich 61'' wird auf das Substrat abgebildet. Das Substrat weist an dem definierten Bereich 61" die veränderte Struktur im Vergleich zu dem durch die Maske teilweise abgedeckten diffusen Bereich auf. Anders ausgedrückt, wird der definierte Bereich 61'' durch die sich kreisförmig bewegende Maske permanent strukturiert, wohingegen der den definierten Bereich 61" umgebenden Bereich zum Teil und in Abhängigkeit von der Position durch die Maske abgedeckt und somit eine weniger starke Veränderung erfährt, da er nur teilweise deponiert wird.

Der definierte, abgebildete Bereich 61'' weist eine um etwa 96 % geringere Fläche auf, als die Maskenöffnung 61'. Die kontinuierliche Deposition führt zu dem grau unterlegten, diffus definiertem Bereich in der Umgebung des definierten Bereichs 61", der durch die deponierte Gesamtfläche der sich kreisförmig bewegenden Maskenöffnung 61' über dem Substrat gegeben ist. Der diffus definierte graue Bereich rechts unten in Fig. 6 ist allerdings aus Platzgründen nicht maßstabsgetreu zu den übrigen Teilen der Figur wiedergegeben.

In Fig. 7 ist in Analogie zur Fig. 5 die Endposition der Maskenöffnung 71' für den Abschluss des definierten Bereichs 71'' und zur Bildung der kreisförmigen Struktur in oder auf einem Substrat mit der Startposition von Maskenöffnung 72' identisch. Selbiges gilt für die Endposition von Maskenöffnung 72' in Bezug auf die Startposition von Maskenöffnung 71'. Die Masken 71 und 72 führen jeweils halbkreisförmige Bewegungen mit insgesamt 12 Positionen inklusive Start- und Zielposition aus, um einen kreisförmigen Bereich 71'' zu definieren, welcher auf das Substrat abgebildet wird. Der Bewegungsablauf jeder Maskenöffnung 71', 72' kann nach Erreichen der Endposition jeweils zu einer vollständig kreisförmigen Bewegung weitergeführt oder an die jeweilige Startposition zurückgeführt werden. In dem letzten Fall führen beide Masken jeweils nur halbkreisförmige Hin- und Herbewegungen aus, welche erst zusammen mit der anderen Maske den kreisförmigen, definierten Bereich 71" bilden. In dem ersten Fall, führen beide Masken für sich bereits kreisförmige Bewegungen aus. Die beiden Masken 71, 72 werden über ein in Bildebene hinter der Öffnung 71' und 72' gelegenes Substrat (nicht dargestellt) bewegt.

Eine Depositionsquelle kann in Bildebene vor den Masken 71, 72 angeordnet sein. Durch eine kontinuierliche Deposition der sich kreisförmig über dem Substrat bewegenden Masken wird über die Öffnungen 71' und 72' der kreisförmige Bereich 71" im Inneren der Maskenöffnungen 71', 72' definiert. Dieser ist erfindungsgemäß viel kleiner als die jeweilige reale Fläche der Öffnung 71', 72' der Masken. Dieser Bereich 71'' wird auf das Substrat abgebildet. Das Substrat weist an dem definierten Bereich 71" die veränderte Struktur im Vergleich zu dem durch die Masken teilweise abgedeckten diffusen Bereich auf, welcher wiederum grau unterlegt ist. Anders ausgedrückt, wird der definierte Bereich 71" durch die sich (halb-)kreisförmig bewegenden Masken permanent deponiert, wohingegen der den definierten Bereich 71'' umgebende Bereich zum Teil und in Abhängigkeit von der Position durch die Masken abgedeckt wird und somit weniger lange deponiert wird. Hierdurch wird letztlich eine weniger starke Veränderung im diffus definierten Bereich (grau unterlegt) erzeugt.

Der definierte, abgebildete Bereich 71'' weist eine um etwa 96 % geringere Fläche auf, als die jeweiligen Maskenöffnungen 71', 72'. Die kontinuierliche Deposition führt zu dem grau unterlegten diffus definierten Bereich in der Umgebung des definierten Bereichs 71''. Die Fläche des diffus definierten Bereichs 71'' wird im Vergleich zu der durch Verwendung von nur einer sich kreisförmig bewegenden Maskenöffnung über dem Substrat (Fig. 6) durch den überlappenden Bereich der Maskenöffnungen 71' und 72' vorteilhaft viel kleiner ausfallen.

Eine Anordnung aus mindestens zwei übereinander angeordneten, sich zum Substrat bewegenden Masken ist also im Vergleich zu einer Maske zu bevorzugen, sofern der diffuse, zeitweilig deponierte Bereich reduziert werden soll.

In Fig. 8 sind die Startpositionen von insgesamt vier Maskenöffnungen 81', 82', 83' und 84' zur Erzeugung eines definierten kreisförmigen Bereichs 81'' und zur Bildung der Struktur in oder auf einem Substrat gezeigt. Zur Bildung der kreisförmigen Struktur in oder auf einem Substrat müssen die Öffnungen 81', 82', 83' und 84' für sich oder zusammen mit den übrigen Maskenöffnungen durch die Bewegung einen Kreis auf dem Substrat abbilden. Die Startposition von Maskenöffnung 81' kann dabei mit der Endposition von Maskenöffnung 82' identisch sein. Die Endposition von Maskenöffnung 81' kann mit der Startposition von Maskenöffnung 84' identisch sein. Selbiges Prinzip gilt für die übrigen Maskenöffnungen.

Die Masken können mit ihren Öffnungen dann jeweils viertelkreisförmige Bewegungen mit insgesamt 7 Positionen (inklusive Start- und Zielposition) ausführen, um einen kreisförmigen Bereich 81'' zu definieren, wie in Fig. 8 rechts oben wiedergegeben ist. Der Bewegungsablauf der Maskenöffnungen 81', 82', 83' und 84' wird dann entweder auf der Kreisbahn weitergeführt oder an die jeweilige Startposition zurückgeführt. In dem letzten Fall führen alle Masken jeweils viertelkreisförmige Bewegungen aus, die erst zusammen mit den anderen Masken den kreisförmigen, definierten Bereich 81'' erzeugen. Die Bewegungen der Maskenöffnungen werden hin- und hergeführt, wie für Fig. 7 beschrieben. In dem ersten Fall, führen alle Masken für sich bereits kreisförmige Bewegungen aus. Die Masken werden über ein in Bildebene hinter der Öffnung 81' und 82', 83' und 84' gelegenes Substrat (nicht dargestellt) bewegt.

Eine Depositionsquelle kann in Bildebene vor den Masken angeordnet sein. Durch eine kontinuierliche Deposition der sich über dem Substrat bewegenden Masken wird über die Öffnungen 81', 82', 83' und 84' der kreisförmige Bereich 81'' im Inneren der Maskenöffnungen 81', 82', 83' und 84' definiert, der kleiner ist als die jeweilige Fläche der Öffnung 81', 82', 83' und 84' der Masken. Dieser Bereich 81'' wird auf das Substrat abgebildet. Das Substrat weist an dem definierten Bereich 81'' eine deutlich veränderte Struktur im Vergleich zu den durch die Masken teilweise abgedeckten diffusen Bereichen auf. Anders ausgedrückt, wird der definierte Bereich 81'' durch die sich kreisförmig bewegenden Masken permanent deponiert, wohingegen der den definierten Bereich 81'' umgebende Bereich zum allergrößten Teil und in Abhängigkeit von der Position durch die Masken abgedeckt wird und somit fast gar keine Veränderung erfährt.

Der definierte, abgebildete Bereich 81" weist eine um etwa 96 % geringere Fläche auf, als die jeweiligen Maskenöffnungen 81', 82', 83' und 84'. Die kontinuierliche Deposition führt zu den vier grau unterlegten diffus definierten Bereichen ausschließlich in der unmittelbaren Umgebung des definierten Bereichs 81''. Die Fläche der diffus definierten, grauen Bereiche wird im Vergleich zu der durch Verwendung von nur einer oder zwei sich kreisförmig bewegender Maskenöffnungen über dem Substrat, wie in Fig. 6 und 7 gezeigt, um ein Vielfaches kleiner ausfallen, da durch den überlappenden Bereich der Maskenöffnungen 81', 82', 83' und 84 bei kreisförmiger Bewegung der Masken der Großteil des Substrats durch die soliden Bereiche der Masken auch bei deren Bewegung abgedeckt bleibt. Wie gezeigt, werden nur an vier äußeren Zipfeln des definierten Bereichs 81'' sehr kleine diffuse Bereiche erzeugt, die in der Fig. 8 rechts unten grau unterlegt sind.

Das erfindungsgemäße Verfahren kann auch ganz ohne eine Bewegung von Masken durchgeführt werden. Hierzu müssen mindestens zwei Masken 91 und 92 mit Öffnungen 91' und 92' axial übereinander und zueinander in X- und/oder Y-Richtung versetzter Position über dem Substrat angeordnet werden.

In z-Richtung werden somit nacheinander das Substrat, darüber die Masken und wiederum darüber die Strukturierungsquelle, z. B. eine Depositionsquelle angeordnet.

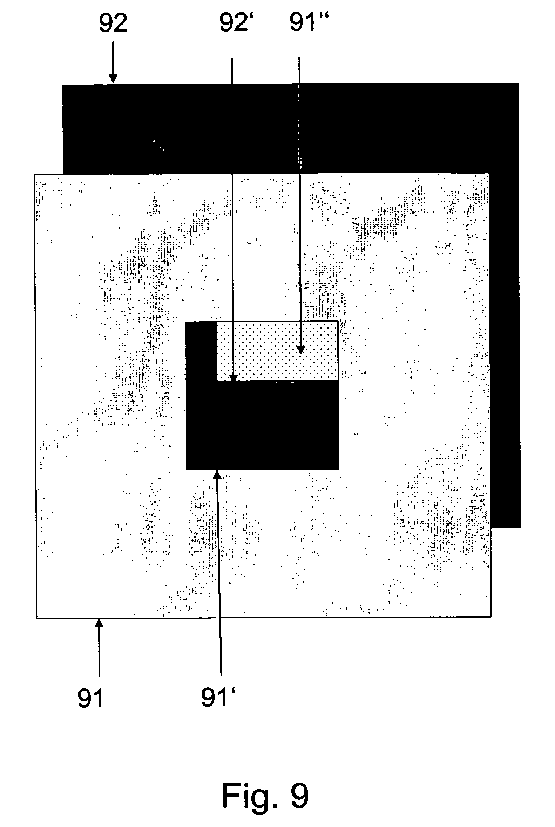

Fig. 9 zeigt eine solche Anordnung mit wiederum quadratischen Masken und allerdings quadratischen Maskenöffnungen 91', 92'. Auf diese Weise wird bei kontinuierlicher Strukturierung der definierte Bereich 91'' erzeugt, welcher in der Fig. 9 punktiert dargestellt ist und rechteckige Abmessungen aufweist. Auch dabei wird während des Verfahrens die Abbildung der Maskenöffnungen auf dem Substrat kleinere Abmessungen aufweisen, als die realen Maskenöffnungen selbst.

Je nach Versetzung in X- und/oder Y-Richtung der Masken 91, 92 zueinander, werden mehr oder weniger kleine definierte Bereiche 91'' in oder auf dem in Bildebene hinter den Masken angeordnetem Substrat durch Abbildung erzeugt. Dieses Verfahren bietet den Vorteil, die Masken und das Substrat ortsfest belassen zu können.

Es ist denkbar, eine Vielzahl von Öffnungen in den beiden Masken gemäß Ausführungsbeispiel 9 in identischer Weise anzuordnen. Bei Versetzung der Masken in X-und oder Y-Richtung zueinander, werden bei kontinuierlicher Strukturierung, z. B. durch eine Deposition, eine entsprechende Anzahl identischer, kleinerer Strukturen als die Maskenöffnungen in oder auf dem Substrat erzeugt.

Die Versetzung der Masken zueinander in X- und/oder Y-Position kann beibehalten werden, um nach einer Deposition beide Masken mit Öffnungen in identischer Weise über das Substrat zu bewegen. Während der Bewegung kann die Deposition ausgeschaltet sein, um diffuse Bereiche zu vermeiden. So werden, bei einfach gehaltener Maskenanordnung, dieselben Strukturen in oder auf dem Substrat erzeugt.

Alle in den Ausführungsbeispielen genannten Möglichkeiten, Masken mit bestimmten Öffnungen zu versehen und auf geometrisch definierte Weise zu bewegen und Strukturierungen, z. B. eine Deposition kontinuierlich oder diskontinuierlich durchzuführen, um definierte Bereiche in oder auf einem Substrat zu erzeugen, können frei kombiniert werden.

Keineswegs sind die Maskenanordnungen auf die Ausführungsbeispiele beschränkt. Vielmehr sind für eine Maske verschiedene Öffnungen vorstellbar, die für sich oder in Kombination mit weiteren Masken ortsfest gehalten oder bewegt werden, um auf diese Weise zu Strukturen zu gelangen, die kleiner sind als die durch die Maskenöffnung größenlimitierten Strukturen und/oder zudem eine andere Form aufweisen als die Maskenöffnungen. Auch die Anzahl der angegebenen Bewegungsschritte ist nur beispielhaft.

An Stelle der Masken kann während der Verfahren das Substrat oder eine auf dem Substrat angeordnete Schicht bewegt werden.

Durch das Verfahren können definierte Bereiche von beispielsweise 1 Nanometer schnell und präzise erzeugt werden.

Je nach Maskenöffnung kann eine Implantation oder Deposition von Materialien (Ionen, Metalle und so weiter) vorgenommen werden.

Die Bewegungsgeschwindigkeit der Masken über dem Substrat hängt dabei von der Vorrichtung ab, mit der das Verfahren durchgeführt wird.

Ein Nanomanipulator mit Piezoelementen kann die Bewegungen der Masken durch Ansteuerung im kHz-Bereich also im Mikrosekundenbereich durchführen. Piezoelemente können die Masken entweder direkt oder indirekt über Objektträger, in denen die Masken gehalten werden, bewegen. Mindestens ein Piezolement kann dazu seitlich an der oder den Masken angeordnet sein.

Durch diskontinuierliche Strukturierung und Wiederholung des Bewegungsablaufs der Masken kann eine andere Struktur für den diffus definierten Bereich erzeugt werden (siehe auch Fig. 2).

Werden, wie in den Fig. 5, 7, 8, 9 und 10 gezeigt, mehrere Masken verwendet, so kann der axiale Abstand der Masken zueinander in z-Richtung im Nanomanipulator wenige Nanometer betragen.

Der in den Ausführungsbeispielen definierte Bereich kann je nach Bewegungsablauf der Maske auch kleiner oder größer sein. Durch gezielt durchgeführte Überlappungen sind ebenfalls Strukturen definierbar, die größer als die Maske sind.

An Stelle der Deposition als Strukturierung kann eine Implantation verwendet werden.

## Patentansprüche

1. Verfahren zur Strukturierung eines Substrats durch Deposition oder Implantation, bei dem über dem Substrat mindestens eine Maske mit einer Öffnung angeordnet ist und unmaskierte Bereiche gegenüber maskierten Bereichen des Substrats zur Bildung von Strukturen verändert werden, wobei während der Strukturierung eine Abbildung der Maskenöffnung auf und/oder in dem Substrat erzeugt wird, welche kleinere Abmessungen aufweist, als die Abmessung der Maskenöffnung,
**dadurch gekennzeichnet, dass**
die Veränderung der Fläche der Maskenöffnung(en) durch eine Diodenanordnung kontrolliert wird.

2. Verfahren nach Anspruch 1,
**dadurch gekennzeichnet, dass**
mindestens zwei Masken mit Öffnungen in z-Richtung übereinander und in X- und Y-Richtung in zueinander versetzter Position auf dem Substrat angeordnet werden.

3. Verfahren nach einem der vorhergehenden Ansprüche,
**dadurch gekennzeichnet, dass**
während des Verfahrens mindestens eine Maske relativ zum Substrat bewegt wird.

4. Verfahren nach einem der vorhergehenden Ansprüche,
**dadurch gekennzeichnet, dass**
während des Verfahrens auf und/oder in dem Substrat eine Struktur mit einer zur Maskenöffnung verschiedenen geometrischen Form erzeugt wird.

5. Verfahren nach einem der vorhergehenden Ansprüche,
**dadurch gekennzeichnet, dass**
in Abhängigkeit von der gewählten Geometrie des Bewegungsablaufs relativ zwischen Substrat und Maskenöffnung(en) die Geometrie der Struktur im Substrat erzeugt wird.

6. Verfahren nach einem der vorhergehenden Ansprüche,
**dadurch gekennzeichnet, dass**
die Strukturierung und/oder der Bewegungsablauf relativ zwischen Substrat und Maske(n) diskontinuierlich durchgeführt werden.

7. Verfahren nach einem der vorhergehenden Ansprüche,
**dadurch gekennzeichnet, dass**
zur Ausführung der Relativbewegung ein Trägheitsantrieb gewählt wird.

8. Verfahren nach einem der vorhergehenden Ansprüche,
**dadurch gekennzeichnet, dass**
zumindest eine Maske gewählt wird, welche einen Glasträger mit einer darauf aufgebrachten Metallschicht umfasst.

9. Verfahren nach einem der vorhergehenden Ansprüche,
**dadurch gekennzeichnet, dass**
zumindest eine Maske mit einer kreisförmigen und/oder viereckigen Öffnung gewählt wird.

10. Verfahren nach einem der vorhergehenden Ansprüche,
**dadurch gekennzeichnet, dass**
eine Maske umfassend magnetisches Material gewählt wird.

11. Verfahren nach einem der vorhergehenden Ansprüche, bei dem mindestens eine Maske Bewegungen entlang eines gleichschenkligen Dreiecks oder horizontal elliptische Bewegungen oder eine quadratische Bewegung oder eine kreisförmige Bewegung oder halbkreisförmige Bewegung ausführt.

12. Verfahren nach einem der vorhergehenden Ansprüche,
**dadurch gekennzeichnet, dass**
die Position der Maske(n) relativ zum Substrat über optische, interferometrische und/oder kapazitive Sensoren bestimmt wird.

13. Vorrichtung zur Durchführung des Verfahrens nach einem der vorhergehenden Ansprüche 1 bis 12,
mit mindestens zwei in z-Richtung auf dem Substrat übereinander angeordneten Masken, deren Maskenöffnungen in X- und/oder Y-Richtung zueinander versetzt sind sowie einer Depositions- oder Implantationsquelle zur Strukturierung des Substrats,
**dadurch gekennzeichnet, dass**
die Vorrichtung eine Diodenanordnung zur Kontrolle der Veränderung der Fläche der Maskenöffnungen aufweist.

14. Vorrichtung zur Durchführung des Verfahrens nach einem der vorhergehenden Ansprüche 1 bis 12,
wobei die Vorrichtung Mittel zur Ausführung von Bewegungen relativ zwischen mindestens einer Maske mit einer Maskenöffnung und dem Substrat sowie eine Depositions- oder Implantationsquelle zur Strukturierung des Substrats umfasst,
**dadurch gekennzeichnet, dass**
die Vorrichtung eine Diodenanordnung zur Kontrolle der Veränderung der Fläche der Maskenöffnungen aufweist.

15. Vorrichtung nach einem der vorhergehenden Ansprüche 13 oder 14,
**dadurch gekennzeichnet, dass**
die Vorrichtung Mittel zur Ausführung von Bewegungen relativ zwischen den Masken mit den Maskenöffnungen und dem Substrat umfasst.

16. Vorrichtung nach Anspruch 13 bis 15,
**dadurch gekennzeichnet, dass**
die Vorrichtung als Mittel zur Ausführung von Bewegungen Mikro- und/oder Nanoaktuatoren umfasst.

17. Vorrichtung nach einem der vorhergehenden Ansprüche 13 bis 16,
**dadurch gekennzeichnet, dass**
die Vorrichtung als Mittel zur Ausführung von Bewegungen mindestens ein Piezoelement umfasst.

18. Vorrichtung nach einem der vorhergehenden Ansprüche 13 bis 17,
**dadurch gekennzeichnet, dass**
die Vorrichtung mindestens einen über die Mittel zur Ausführung von Bewegungen bewegbaren Objektträger umfasst.

19. Vorrichtung nach einem der vorhergehenden Ansprüche 13 bis 18,
**dadurch gekennzeichnet, dass**
die Vorrichtung einen Objektträger aus magnetischem Material umfasst.

20. Vorrichtung nach einem der vorhergehenden Ansprüche 13 bis 19,
**dadurch gekennzeichnet, dass**
die Mittel zur Bewegung Bestandteil eines Nanomanipulators sind.

21. Vorrichtung nach einem der vorhergehenden Ansprüche 13 bis 20,
**dadurch gekennzeichnet, dass**
diese eine Steuerungseinheit, insbesondere einen PC zur Ausführung von Relativbewegungen zwischen Maske(n) und Substrat im Nanometerbereich umfasst.

22. Vorrichtung nach einem der vorhergehenden Ansprüche 13 bis 21,
**dadurch gekennzeichnet, dass**
diese diskontinuierliche Bewegungs- und/oder Strukturierungsabläufe auszuführen vermag.

23. Vorrichtung nach einem der vorhergehenden Ansprüche 13 bis 22,
bei der mindestens eine Maske Bewegungen entlang eines gleichschenkligen Dreiecks, oder horizontal elliptische Bewegungen oder quadratische Bewegungen oder kreisförmige Bewegungen oder halbkreisförmige Bewegungen auszuführen vermag.

24. Vorrichtung nach einem der vorhergehenden Ansprüche 13 bis 23,
**dadurch gekennzeichnet, dass**
die Position der Maske(n) relativ zum Substrat mit optischen, interferometrischen oder kapazitiven Sensoren bestimmt wird.

25. Vorrichtung nach einem der vorhergehenden Ansprüche 13 bis 24,
bei der die Diodenanordnung unterhalb der Maskenöffnungen angeordnet ist.

26. Vorrichtung nach einem der vorhergehenden Ansprüche 13 bis 25,
**dadurch gekennzeichnet, dass**
mittels der Diodenanordnung ein UV-Strahl zur Kontrolle der Verstopfung der Masken auf die Maskenöffnungen richtbar ist.

## Claims

1. Method of patterning a substrate by deposition or implantation, in which at least one mask with an opening is arranged over the substrate and unmasked regions of the substrate are varied relative to masked regions of the substrate in order to form patterns, an image of the mask opening with smaller dimensions than those of the mask opening being produced on and/or in the substrate during the patterning process, **characterised in that** the variation in the surface area of the mask opening(s) is controlled by a diode array.

2. Method according to claim 1, **characterised in that** at least two masks with openings are arranged on the substrate one over the other in the z-direction and offset from one another in the X- and Y-directions.

3. Method according to one of the preceding claims, **characterised in that** at least one mask is moved relative to the substrate during the method.

4. Method according to one of the preceding claims, **characterised in that** a pattern with a different geometric shape from the mask opening is produced on and/or in the substrate during the method.

5. Method according to one of the preceding claims, **characterised in that** the geometry of the pattern in the substrate is produced as a function of the selected geometry of the sequence of relative movements between the substrate and the mask opening(s).

6. Method according to one of the preceding claims, **characterised in that** the patterning and/or the sequence of relative movements between the substrate and the mask(s) is/are carried out discontinuously.

7. Method according to one of the preceding claims, **characterised in that** an inertia drive is selected to execute the relative movement.

8. Method according to one of the preceding claims, **characterised in that** at least one mask including a glass support with a metal layer applied thereto is selected.

9. Method according to one of the preceding claims, **characterised in that** at least one mask with a circular and/or square opening is selected.

10. Method according to one of the preceding claims, **characterised in that** a mask including magnetic material is selected.

11. Method according to one of the preceding claims, in which at least one mask executes movements along an isosceles triangle or horizontally elliptical movements or a square movement or a circular movement or semi-circular movement.

12. Method according to one of the preceding claims, **characterised in that** the position of the mask(s) relative to the substrate is determined by means of optical, interferometric and/or capacitive sensors.

13. Device for carrying out the method according to one of the preceding claims 1 to 12, comprising at least two masks arranged one over the other on the substrate in the z-direction with their mask openings offset from one another in the X- or Y-direction(s) and a deposition or implantation source for patterning the substrate, **characterised in that** the device has a diode array for controlling the variation in the surface area of the mask openings.

14. Device for carrying out the method according to one of the preceding claims 1 to 12, in which the device includes means for executing relative movements between at least one mask with a mask opening and the substrate and a deposition or implantation source for patterning the substrate, **characterised in that** the device has a diode array for controlling the variation in the surface area of the mask openings.

15. Device according to one of the preceding claims 13 or 14, **characterised in that** the device includes means for executing relative movements between the masks with the mask openings and the substrate.

16. Device according to claims 13 to 15, **characterised in that** the device includes microactuators and/or nanoactuators as means for executing movements.

17. Device according to one of the preceding claims 13 to 16, **characterised in that** the device includes at least one piezoelectric element as means for executing movements.

18. Device according to one of the preceding claims 13 to 17, **characterised in that** the device includes at least one slide movable by means of the means for executing movements.

19. Device according to one of the preceding claims 13 to 18, **characterised in that** the device includes a slide made of magnetic material.

20. Device according to one of the preceding claims 13 to 19, **characterised in that** the means for executing movements are part of a nanomanipulator.

21. Device according to one of the preceding claims 13 to 20, **characterised in that** it includes a control unit, in particular a PC for executing relative movements between the mask(s) and the substrate in the nanometre range.

22. Device according to one of the preceding claims 13 to 21, **characterised in that** it can execute discontinuous sequences of movements and/or patterning sequences.

23. Device according to one of the preceding claims 13 to 22, in which at least one mask can execute movements along an isosceles triangle or horizontally elliptical movements or square movements or circular movements or semi-circular movements.

24. Device according to one of the preceding claims 13 to 23, **characterised in that** the position of the mask(s) relative to the substrate is determined by means of optical, interferometric or capacitive sensors.

25. Device according to one of the preceding claims 13 to 24, in which the diode array is arranged below the mask openings.

26. Device according to one of the preceding claims 13 to 25, **characterised in that** a UV beam can be directed towards the mask openings by means of the diode array to control clogging of the masks.

## Revendications

1. Procédé de structuration d'un substrat par dépôt ou implantation, où au moins un masque avec une ouverture est disposé au-dessus du substrat et des zones non masquées modifiées par rapport à des zones masquées du substrat pour former des structures, une représentation de l'ouverture de masque étant générée sur et / ou dans le substrat pendant la structuration, laquelle présente des dimensions inférieures à celles de l'ouverture de masque,
**caractérisé en ce que** la modification de la surface de l'ouverture de masque (des ouvertures de masque) est contrôlée par un agencement de diodes.

2. Procédé selon la revendication 1, **caractérisé en ce qu'**au moins deux masques avec des ouvertures sont disposés sur le substrat en superposition en direction z et en positions décalées l'un par rapport à l'autre en direction X et en direction Y.

3. Procédé selon l'une des revendications précédentes, **caractérisé en ce qu'**au moins un masque est déplacé relativement au substrat en cours de procédé.

4. Procédé selon l'une des revendications précédentes, **caractérisé en ce qu'**une structure avec une forme géométrique différente de l'ouverture de masque est générée sur et / ou dans le substrat en cours de procédé.

5. Procédé selon l'une des revendications précédentes, **caractérisé en ce que** la géométrie de la structure est générée dans le substrat en fonction de la géométrie sélectionnée pour le déplacement relatif entre le substrat et l'ouverture de masque (les ouvertures de masque).

6. Procédé selon l'une des revendications précédentes, **caractérisé en ce que** la structuration et / ou le déplacement relatif entre le substrat et le masque (les masques) sont exécutés de manière discontinue.

7. Procédé selon l'une des revendications précédentes, **caractérisé en ce qu'**un moteur à inertie est choisi pour exécuter le mouvement relatif.

8. Procédé selon l'une des revendications précédentes, **caractérisé en ce qu'**au moins un masque comprenant un support en verre avec une couche métallique appliquée sur celui-ci est choisi.

9. Procédé selon l'une des revendications précédentes, **caractérisé en ce qu'**au moins un masque avec une ouverture circulaire et / ou carrée est choisi.

10. Procédé selon l'une des revendications précédentes, **caractérisé en ce qu'**un masque comprenant un matériau magnétique est choisi.

11. Procédé selon l'une des revendications précédentes, où au moins un masque exécute des mouvements le long d'un triangle équilatéral, ou des mouvements horizontaux elliptiques, ou un mouvement carré, ou un mouvement circulaire ou semi-circulaire.

12. Procédé selon l'une des revendications précédentes, **caractérisé en ce que** la position du masque (des masques) relativement au substrat est déterminée par des capteurs optiques, interférométriques et / ou capacitifs.

13. Dispositif pour l'exécution du procédé selon l'une des revendications 1 à 12,
avec au moins deux masques disposés sur le substrat en superposition en direction z, dont les ouvertures de masque sont décalées l'une par rapport à l'autre en direction X et / ou en direction Y, ainsi qu'une source de dépôt ou d'implantation pour la structuration du substrat,
**caractérisé en ce que** le dispositif comprend un agencement de diodes pour le contrôle de modification de la surface des ouvertures de masque.

14. Dispositif pour l'exécution du procédé selon l'une des revendications 1 à 12,
ledit dispositif comprenant des moyens pour l'exécution de mouvements relatifs entre au moins un masque avec une ouverture de masque et le substrat, ainsi qu'une source de dépôt ou d'implantation pour la structuration du substrat,
**caractérisé en ce que** le dispositif comprend un agencement de diodes pour le contrôle de modification de la surface des ouvertures de masque.

15. Dispositif selon l'une des revendications 13 et 14, **caractérisé en ce que** le dispositif comprend des moyens pour l'exécution de mouvements relatifs entre les masques avec les ouvertures de masque et le substrat.

16. Dispositif selon les revendications 13 à 15, **caractérisé en ce que** le dispositif comprend des micro- et / ou des nano-actionneurs en tant que moyens pour l'exécution de mouvements.

17. Dispositif selon l'une des revendications 13 à 16, **caractérisé en ce que** le dispositif comprend au moins un piézo-élément en tant que moyen pour l'exécution de mouvements.

18. Dispositif selon l'une des revendications 13 à 17, **caractérisé en ce que** le dispositif comprend au moins un support d'objet déplaçable par les moyens pour l'exécution de mouvements.

19. Dispositif selon l'une des revendications 13 à 18, **caractérisé en ce que** le dispositif comprend un support d'objet en matériau magnétique.

20. Dispositif selon l'une des revendications 13 à 19, **caractérisé en ce que** les moyens de mouvement font partie d'un nano-manipulateur.

21. Dispositif selon l'une des revendications 13 à 20, **caractérisé en ce que** ledit dispositif comprend une unité de commande, en particulier un PC pour l'exécution de mouvements relatifs entre le masque (les masques) et le substrat dans la plage nanométrique.

22. Dispositif selon l'une des revendications 13 à 21, **caractérisé en ce que** ledit dispositif peut exécuter des déplacements et / ou des structurations discontinus.

23. Dispositif selon l'une des revendications 13 à 22, où au moins un masque peut exécuter des mouvements le long d'un triangle équilatéral, ou des mouvements horizontaux elliptiques, ou des mouvements carrés, ou des mouvements circulaires ou semi-circulaires.

24. Dispositif selon l'une des revendications 13 à 23, **caractérisé en ce que** la position du masque (des masques) relativement au substrat est déterminée par des capteurs optiques, interférométriques ou capacitifs.

25. Dispositif selon l'une des revendications 13 à 24, où l'agencement de diodes est disposé en-dessous des ouvertures de masque.

26. Dispositif selon l'une des revendications 13 à 25, **caractérisé en ce que**, au moyen de l'agencement de diodes, un rayon UV est dirigeable vers les ouvertures de masque pour le contrôle d'obstruction des masques.
